# EUROPEAN PATENT APPLICATION

(11) **EP 1 995 802 A2**
(43) Date of publication of application: **26.11.2008**
(21) Application number: 08156525.1
(22) Date of filing: 20.05.2008
(51) Int. Cl.: H01L 51/56

(54) **Method for manufacturing organic el element**

(30) Priority: 24.05.2007 JP 2007138208
(71) Applicant: Kabushiki Kaisha Toyota Jidoshokki, Kariya-shi, Aichi 448-8671 (JP)
(72) Inventor: Sone, Hirotaka, Kariya-shi Aichi 448-8671 (JP); Okuni, Toshio, Kariya-shi Aichi 448-8671 (JP); Yoshino, Kimihiko, Kariya-shi Aichi 448-8671 (JP)
(74) Representative: TBK-Patent

(57) **Abstract**

A substrate mark (13) is formed on a transparent substrate (11) as an alignment mark. The substrate mark (13) is formed at the same time as transparent electrodes (12) are formed on the transparent substrate (11). The substrate mark (13) is formed of the same material as the transparent electrodes (12). A center wavelength of a transmission wavelength of a plurality of optical filters (17) is different from each other. An optical filter (17) corresponding to a thickness of the substrate mark (13) is selected from a plurality of optical filters (17). Light is irradiated from a white light source (16) to the substrate mark (13) via the selected optical filter (17). Accordingly, the substrate mark (13) is recognized and a shadow mask (14) is aligned with the transparent substrate (11).

## Description

### BACKGROUND OF THE INVENTION

The present invention relates to a method for manufacturing an organic EL element. EL represents an electroluminescence. The manufacturing method includes a step of forming a transparent electrode on a transparent substrate, a step of aligning shadow mask with the transparent substrate after the electrode forming step, and a step of laminating an organic EL layer on the transparent electrode by deposition after the aligning step.

Recently, attention has been focused on an organic electroluminescence element which is a light-emitting element of a self light emitting type. A basic method for manufacturing an organic EL element includes a step of preparing a glass substrate where an anode which is a transparent electrode is patterned and a step of laminating the organic EL layer and a cathode on the glass substrate. The organic EL layer has a laminated structure including a hole transport layer, a light-emitting layer, and an electron transport layer. A hole injection layer may be provided between the anode and the hole transport layer, and an electron injection layer may be provided between the cathode and the electron transport layer. A light-emitting layer emitting white light may be formed by only one layer or may be formed by laminating a red light-emitting layer, a green light-emitting layer and a blue light-emitting layer.

When each layer of the organic EL element is formed on the substrate, the substrate is arranged in a vacuum chamber and the substrate is covered with a mask with close contact. The mask has a plurality of openings which are formed to have a predetermined minute pattern. An organic raw material is evaporated in the vacuum chamber and passes through the openings of the mask. Accordingly, the organic raw material is deposited on the substrate. As a result, the organic EL element is manufactured. Since development of the organic EL element has been headed for color images having high resolution recently, the openings of the mask are formed to be quite minute. Therefore, at each deposition step, the mask having many minute openings needs to be positioned precisely on the substrate where the deposition has been carried out at the previous step.

For positioning the mask with respect to the glass substrate, a substrate mark may be formed on the glass substrate as an alignment mark after the transparent electrode is patterned on the glass substrate. A mask mark is formed on the mask as another alignment mark. The mask is positioned with respect to the glass substrate by using the substrate mark and the mask mark. Generally, the substrate mark is formed by a metal film so as to be visible by irradiation of the white light to the substrate mark at the alignment step.

Conventionally, an exposure device used for manufacturing a semiconductor device has an alignment measurement device. The alignment measurement device positions the mask with respect to a semiconductor wafer prior to the exposure. In the alignment measurement device disclosed in Japanese Laid-Open Patent Publication No. 5-226220, image data having good contrast between the substrate mark and portions except for the substrate mark is obtained. An object of the alignment measurement device is to obtain good contrast even if a surface reflection ratio of a semiconductor wafer, which is a sample that is to be aligned, a height of the substrate mark, a thickness of a resist coated on the semiconductor wafer and other conditions vary.

The alignment measurement device disclosed in the above publication has an irradiation light source for irradiating the substrate mark, a plurality of optical filters, and a wavelength selection device. The irradiation light source has a continuous and flat emission spectrum. Each of the optical filters has a narrow transmission wavelength range. A central wavelength of the transmission wavelength of each of the optical filters is different from each other. The wavelength selection device arranges one of the optical filters on a light path of the irradiation light. The alignment measurement device previously changes the optical filter at the various process steps to measure the substrate mark, and stores the optical filter with which maximum contrast is obtained. When actually measuring the alignment, the alignment measurement device controls the wavelength selection device such that the stored optical filter is positioned on the light path of the irradiation light.

However, when the substrate mark is formed of a metal film, a dedicated step of forming the substrate mark on the glass substrate is required. This increases the manufacturing steps.

The above publication discloses that the contrast of the substrate mark is improved by the irradiation of light via the optical filter. However, there is no description of the manufacturing of the organic EL element in the above publication.

### SUMMARY OF THE INVENTION

It is an objective of the present invention to provide a method for manufacturing an organic EL element that has no dedicated step of forming an alignment mark on a transparent substrate and aligns a shadow mask with the transparent substrate by irradiating light to the alignment mark, the light having an appropriate wavelength corresponding to a thickness of a transparent electrode.

In accordance with one aspect of the present invention, a method for manufacturing an organic EL element is provided. The manufacturing method includes a step of forming transparent electrodes on a transparent substrate and a step of forming a substrate mark on the transparent substrate as an alignment mark. The substrate mark is formed at the same time as the transparent electrodes are formed on the transparent substrate. The substrate mark is formed of the same material as the transparent electrodes. The substrate mark has a thickness. The transparent substrate is arranged above a shadow mask so as to align the shadow mask with the transparent substrate. A white light source and a plurality of optical filters are prepared. A center wavelength of a transmission wavelength of each of the optical filters is different from each other. The optical filter that corresponds to the thickness of the substrate mark is selected from the optical filters. Light is irradiated from the white light source to the substrate mark via the selected optical filter. Accordingly, the shadow mask is aligned with the transparent substrate using the substrate mark. An organic EL layer is laminated on the transparent electrodes by deposition via the shadow mask.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention, together with objects and advantages thereof, may best be understood by reference to the following description of the presently preferred embodiments together with the accompanying drawings in which:
Fig. 1 is a plan view schematically showing a transparent substrate according to a first embodiment of the present invention;
Fig. 2A is a plan view schematically showing a shadow mask which is superimposed on the transparent substrate of Fig. 1;
Fig. 2B is a plan view schematically showing a state in which the shadow mask of Fig. 2A is superimposed on the transparent substrate of Fig. 1;
Fig. 3 is a side view showing an operation for aligning the shadow mask of Fig. 2A with the transparent substrate of Fig. 1;
Fig. 4 is a graph showing a relationship between a film thickness of an ITO film and transmittance of incoming light;
Fig. 5A is a plan view schematically showing a transparent substrate according to a second embodiment;
Fig. 5B is a plan view schematically showing a shadow mask which is superimposed on the transparent substrate of Fig. 5A;
Fig. 5C is a plan view schematically showing a state in which the shadow mask of Fig. 5B is superimposed on the transparent substrate of Fig. 5A;
Fig. 5D is an enlarged view of Fig. 5C, showing positional relationship between a substrate mark and a mask mark; and
Fig. 6 is a side view schematically showing an operation for aligning a shadow mask with a transparent substrate with a transmission method according to a modified embodiment.

### DETAILED DESCRIPTION OF THE PREFERRED EMBODIMENTS

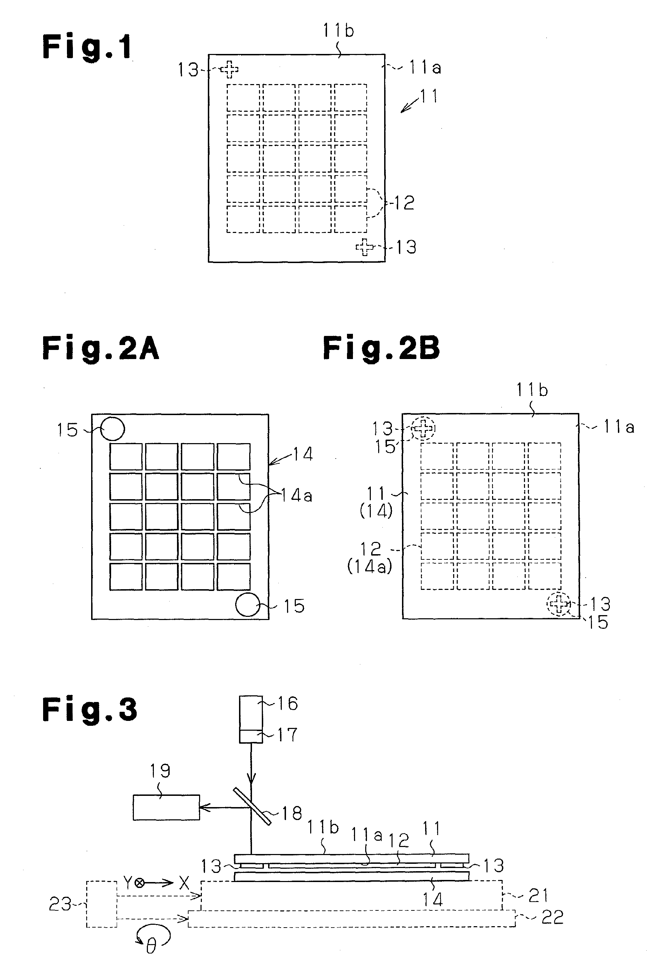

A method for manufacturing an organic EL element according to a first embodiment of the present invention will be explained with reference to Figs. 1 to 4.

The organic EL element has a first electrode, an organic EL layer (not shown), and a second electrode (not shown) which are laminated on a transparent substrate in this order. The first electrode is a transparent electrode 12, and the organic EL layer includes a plurality of thin film layers. The method for manufacturing the organic EL element includes a step of forming the transparent electrode 12 on the transparent substrate 11, a step of forming the organic EL layer on the transparent electrode 12, and a step of forming a second electrode on the organic EL layer, in this order.

The thin film layers of the organic EL layer are formed by laminating through deposition using a shadow mask 14. The thin film layers are formed on the transparent substrate 11 with high precision so as to have a predetermined pattern. Therefore, the shadow mask 14 having a plurality of minute openings 14a for forming the thin films needs to be positioned with respect to the transparent substrate 11.

In the first embodiment, a glass substrate is used for the transparent substrate 11. The transparent electrodes 12 are made of ITO (indium-tin-oxide) which is used for the transparent electrode of known organic EL elements.

As shown in Fig. 1, the transparent substrate 11 is formed in a rectangle. The transparent substrate 11 has a first surface 11a where the transparent electrodes 12 are formed and a second surface 11b that is an opposite side of the first surface 11a. Fig. 1 shows the second surface 11b. Two substrate marks 13 are formed on the first surface 11a. The substrate marks 13 function as alignment marks used for adjusting the position of the shadow mask 14 with respect to the transparent substrate 11. The substrate marks 13 are provided at predetermined positions that are outside of an area of the transparent substrate 11 where the transparent electrodes 12 are formed. The substrate marks 13 are formed of a material same as that of the transparent electrodes 12. The two substrate marks 13 are positioned on a diagonal of the transparent substrate 11. Each of the substrate marks 13 is formed in a cross shape.

The substrate marks 13 are formed on the predetermined positions at the same time as the transparent electrodes 12 are formed on the transparent substrate 11 in the step of forming the transparent electrodes 12. The step of forming the transparent electrodes 12 is one of the steps in the method for manufacturing an organic EL element.

Specifically, the transparent electrodes 12 are formed in the following steps. An ITO film is formed on the transparent substrate 11 made of glass with a known thin film forming method. A resist pattern is formed on the ITO film through photolithography. Thereafter, the transparent electrodes 12 are patterned by etching.

In the first embodiment, when patterning the transparent electrodes 12, a pattern corresponding to the substrate marks 13 are also formed on the resist pattern. As a result, the substrate marks 13 are formed on the transparent substrate 11 at the same time as the transparent electrodes 12 are formed. The thickness of the substrate marks 13 is the same as that of the transparent electrodes 12.

As shown in Fig. 2A, the shadow mask 14 has a plurality of openings 14a so as to form a plurality of organic EL layers on the transparent substrate 11. Two mask marks 15 are formed on the shadow mask 14 as other alignment marks. The mask marks 15 are positioned on a diagonal of the shadow mask 14 similar to the substrate marks 13. In the first embodiment, each circular mask mark 15 is sufficiently large to receive the substrate mark 13 therein. As shown in Fig. 2B, the position of each of the mask mark 15 is determined such that the position of the shadow mask 14 is adjusted with respect to the transparent substrate 11 with high accuracy when the mask mark 15 is superimposed on the substrate mark 13.

An alignment method of the shadow mask 14 with respect to the transparent substrate 11 will be explained with reference to Fig. 3. The deposit film is deposited on the transparent substrate 11 by upward deposition. "Deposition executed by upward deposition" refers to an operation in which the substrate, on which deposition will be carried out, is arranged above the deposition material, and the deposition is carried out in a state that the surface of the substrate to be processed faces downward. Therefore, the shadow mask 14 is aligned with the transparent substrate 11 in a state shown in Fig. 3. In other words, the transparent substrate 11 is positioned above the shadow mask 14. The first surface 11a of the transparent substrate 11 faces downward. The transparent substrate 11 is supported by a support device (not shown) in a state that the first surface 11a on which the transparent electrodes 12 and the substrate marks 13 are formed faces downward. The shadow mask 14 is supported on a XY stage 21. The XY stage 21 is supported by a θ stage 22. A control device 23 controls the XY stage 21 and the θ stage 22. The XY stage 21 is capable of moving the shadow mask 14 in a direction perpendicular to the plane of the drawing, and a horizontal direction in Fig. 3. The θ activation stage 22 is capable of rotating the shadow mask 14 around an axis extending in a vertical direction in Fig. 3. In other words, the shadow mask 14 is rotatable around an axis extending vertically with respect to the first surface 11a of the transparent substrate 11.

As shown in Fig. 3, an irradiation light source 16 as a white light source is provided above the transparent substrate 11. A light source having a continuous and flat emission spectrum such as a white light emitting diode or a halogen lamp is used as the white light source.

As shown in Fig. 3, an optical filter 17 is detachably attached to an irradiation portion of the irradiation light source 16. The optical filter 17 that is attached to the irradiation light source 16 is selected from previously prepared optical filters 17. A central wavelength of the transmission wavelength of each of the optical filter 17 is different from each other. An optical filter 17 having a transmission wavelength corresponding to a thickness of the substrate mark 13 is selected and attached to the irradiation light source 16.

Specifically, "selecting an optical filter 17 corresponding to the thickness of the substrate mark 13" means the following. Since the substrate mark 13 is formed of the same material as the transparent electrodes 12, the wavelength of light which makes the transparent substrate mark 13 visible varies in accordance with the thickness of the substrate mark 13. Therefore, "selecting an optical filter 17 corresponding to the thickness of the substrate mark 13" means that one optical filter is selected from a plurality of optical filters 17 so as to allow the light having the wavelength that makes the substrate mark 13 visible to pass through the substrate 11.

As shown in Fig. 3, a half mirror 18 is provided between the irradiation light source 16 and the transparent substrate 11. The half mirror 18 is arranged as follows. The light irradiated from the irradiation light source 16 toward the transparent substrate 11 passes through the half mirror 18 and the transparent substrate 11 and is reflected by the shadow mask 14. The light reflected by the shadow mask 14 is irradiated to the transparent substrate 11 again and passes through the transparent substrate 11 and is irradiated to the half mirror 18. The light irradiated from the shadow mask 14 to the half mirror 18 does not pass through the half mirror 18 and is reflected by the half mirror 18 so as to advance sideway. A CCD camera 19 is provided on a side of the half mirror 18. The CCD camera 19 receives the light from the half mirror 18.

The control device 23 controls the XY stage 21 and the θ stage 22 based on image data received from the CCD camera 19. As a result, the control device 23 aligns the shadow mask 14 with the transparent substrate 11. The control device 23 adjusts the position of the shadow mask 14 such that the mask marks 15 are aligned with the substrate marks 13 as shown in Fig. 2B. Specifically, the control device 23 aligns the center of the mask mark 15 on the center of the substrate mark 13.

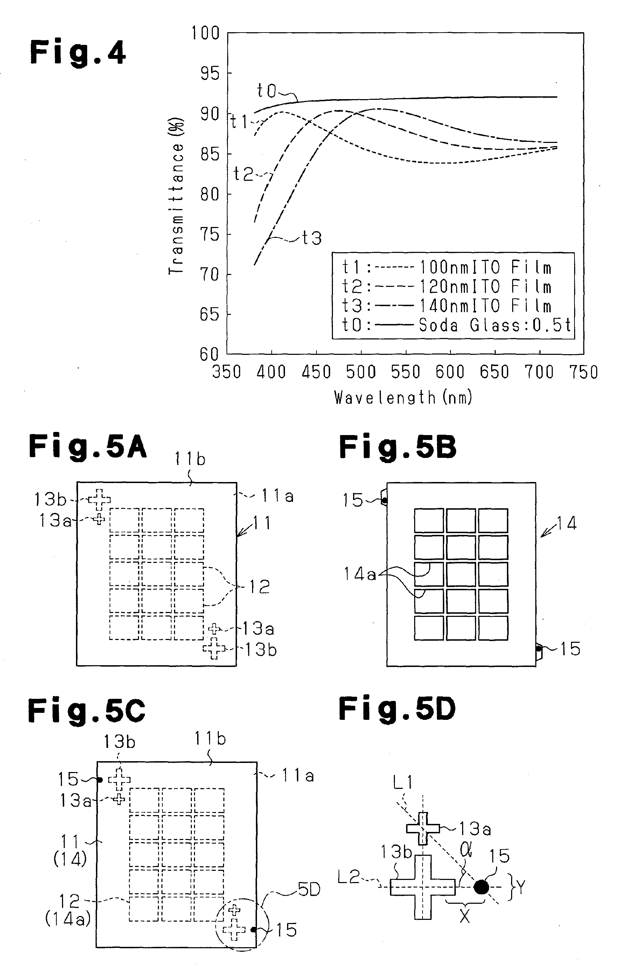

Fig. 4 shows a relationship between the wavelength of the incoming light and the transmittance of each of the soda glass and the ITO film. A comparative curved line to shows the relationship of the soda glass which is used for the transparent substrate 11. The first curved line t1 shows the case in which the ITO film is used for the transparent electrodes 12 and the substrate marks 13, and the thickness of the ITO film is 100 nm. The second curved line t2 shows the case in which the thickness of the ITO film is 120 nm, and the third curved line t3 shows the case in which the thickness of the ITO film is 140 nm. As shown by the comparative curved line t0, the transmittance of the soda glass is approximately 90 % when the wavelength of the irradiation light is in a range of 380 nm to 730 nm. However, as shown by the first curved line t1 to the third curved line t3, the transmittance of the ITO film varies in accordance with the thickness of the ITO film and the wavelength of the irradiation light. If the transmittance is 85 % or less, the substrate marks 13 is recognizable. That is, even when the transparent substrate marks 13 have relatively low transmittance, the light is irradiated from the irradiation light source 16 to the substrate marks 13, passes through the transparent substrate 11, and is reflected by the shadow mask 14. The light which is irradiated again to the transparent substrate 11 is measured, such that the substrate marks 13 becomes recognizable. However, if the transmittance is greater than 85 %, the transparent substrate marks 13 are hardly recognizable.

Therefore, corresponding to the thickness of the substrate marks 13 or the thickness of the transparent electrodes 12, the light having a wavelength of the transmittance of 85 % or less needs to be irradiated to the transparent substrate 11. When the film thickness of the ITO is 100 nm as shown by the first curved line t1 in Fig. 4, it is preferable to use the optical filter 17 of which the center wavelength of the transmission wavelength is 550 nm to 600 nm. When the film thickness of ITO is 120 nm as shown by the second curved line t2, it is preferable to use the optical filter 17 of which the center wavelength of the transmission wavelength is 400 nm or less. When the film thickness of ITO is 140 nm as shown by the third curved line t3, it is preferable to use the optical filter 17 of which the center wavelength of the transmission wavelength is 440 nm or less.

Since the white light source is used as the irradiation light source 16, the emission spectrum of the irradiation light from the irradiation light source 16 is continuous over a large wavelength zone and flat. One appropriate optical filter 17 is selected from a plurality of optical filters 17 each of which has different center wavelength of the transmission wavelength, and the appropriate optical filter 17 is attached to the irradiation light source 16. The appropriate optical filter 17 has an appropriate center wavelength of the transmission wavelength corresponding to the thickness of the transparent electrodes 12. As a result, the irradiation light having an appropriate wavelength is irradiated to the transparent substrate 11 and the substrate marks 13 is recognized.

The transparent substrate 11 is transported in a transfer chamber for laminating the organic EL layer on the transparent substrate 11. The transfer chamber has a plurality of deposition chambers which are connected to each other. In the deposition chambers, each layer comprising the organic EL layer, such as a hole transport layer, a light emitting layer and an electron transport layer, is deposited. A melting pot in which an organic raw material evaporates is provided in each deposition chamber. A transfer robot transports the transparent substrate 11 to the deposition chamber in a state that the transparent electrodes 12 face down. In each deposition chamber, the shadow mask 14 is aligned with the transparent substrate 11 as described above and maintained with a close contact with the transparent substrate 11. The organic raw material which evaporates in each deposition chamber passes through the openings 14a of the shadow mask 14 and is directly deposited on the transparent substrate 11. As a result, each layer comprising the organic EL layer is formed.

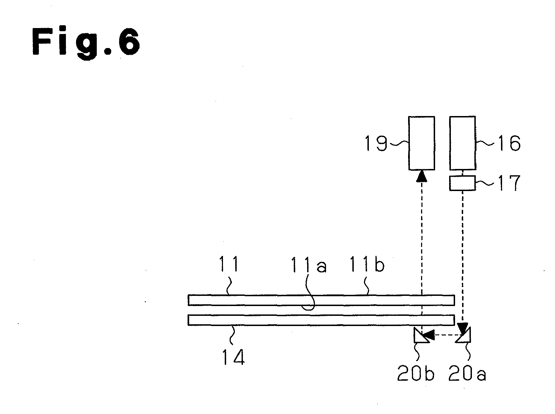

The first embodiment has following advantages.
(1) In the step of forming the transparent electrodes 12, the substrate marks 13 are formed at the same time as the transparent electrodes 12 are formed on the transparent substrate 11. The substrate marks 13 are formed of the same material as the transparent electrodes 12. Each of the substrate marks 13 is formed in a predetermined position on the transparent substrate 11. The substrate mark 13 functions as an alignment mark used for adjusting the position of the shadow mask 14 with respect to the transparent substrate 11. Therefore, a dedicated step of forming the substrate marks 13 is not necessary. This reduces the number of steps.
(2) In the step of aligning the shadow mask 14 with the transparent substrate 11, the transparent substrate 11 is arranged above the shadow mask 14. The irradiation light source 16 as the white light source and a plurality of optical filters 17 are prepared. Each of the optical filters 17 has a different center wavelength of a transmission wavelength. One optical filter 17 having a transmission wavelength corresponding to the thickness of the substrate marks 13 is selected from a plurality of optical filters 17. White light is irradiated from the irradiation light source 16 to the substrate marks 13 via the selected optical filter 17. Accordingly, the transparent substrate marks 13 are recognized and the shadow mask 14 is aligned with the transparent substrate 11. The organic EL layer is laminated on the transparent electrodes 12 by deposition via the shadow mask 14.
   The substrate marks 13 are formed at the same time as the transparent electrodes 12 are formed in the step of patterning the transparent electrodes 12. The thickness of the substrate marks 13 is the same as that of the transparent electrodes 12. That is, the appropriate wavelength of the irradiation light for allowing the substrate marks 13 to be recognized varies in accordance with thickness of the transparent electrodes 12.
   Generally, when the substrate marks 13 formed of a transparent material are irradiated by a general white light source for alignment, it is difficult to visually recognize the substrate marks 13. When the transparent substrate marks 13 are irradiated by a single color light from a LED (light emitting diode) light source, the substrate marks 13 may be hardly visible depending on the film thickness of the substrate marks 13.
   However, in the first embodiment, an appropriate optical filter 17 is selected from a plurality of optical filters 17. Light is irradiated to the substrate marks 13 via the selected optical filter. In the first embodiment, a wavelength of light irradiated to the substrate marks 13 during the alignment operation can be changed corresponding to the thickness of the transparent electrodes 12. Therefore, light of a wavelength having low transmittance corresponding to the thickness of the transparent electrodes 12 is irradiated from the irradiation light source 16 to the substrate marks 13 such that the transparent substrate marks 13 are visible. Therefore, in the first embodiment, it is not necessary to adjust the thickness of the substrate marks 13 such that the thickness corresponds to the irradiation light source 16 that is used for aligning the shadow mask 14 with the transparent substrate 11. In other words, it is not necessary to consider the thickness of the transparent electrodes 12.
   The visibility of the transparent substrate marks 13 is improved in the first embodiment compared to the following case. For example, the visibility of the substrate marks 13 is improved in the first embodiment compared to a case in which it is required to use a lighting device emitting light of a wavelength close to an appropriate wavelength since an LED emitting light having an appropriate wavelength corresponding to the thickness of the transparent electrodes 12 cannot be prepared.
(3) The shadow mask 14 is aligned with the transparent substrate 11 by making the substrate marks 13 visible by a reflection method. Accordingly, the cost of the alignment device is reduced in the first embodiment compared to a method for making the substrate marks recognizable by a transmission method as shown in Fig. 6.
(4) The optical filter 17 is detachably attached to the irradiation light source 16. One optical filter which transmits light having an appropriate wavelength corresponding to the thickness of the transparent electrodes 12 is selected from a plurality of optical filters 17. Therefore, the structure is simple and compact in the first embodiment compared to the following case. For example, a plurality of optical filters each of which has a different transmission wavelength are provided integrally with a filter member with a predetermined distance therebetween. The filter member is moved by a moving device so as to arrange an appropriate optical filter in a light path of irradiation light from the irradiation light source 16. Compared to this structure, the first embodiment has a compact structure.

Figs. 5A to 5D show a second embodiment of the present invention. In the second embodiment, the shapes and positions of the substrate mark 13 and the mask mark 15 are different from those in the first embodiment.

As shown in Fig. 5A, two first substrate marks 13a and two second substrate marks 13b are formed on the transparent substrate 11 instead of the substrate marks 13. The first substrate marks 13a and the second substrate marks 13b have different sizes. As shown in Fig. 5B, the size of the mask mark 15 of the second embodiment is smaller than that of the first substrate mark 13a and that of the second substrate mark 13b. As shown in Fig. 5C, in a state where the shadow mask 14 is aligned on the transparent substrate 11, the first substrate marks 13a and the second substrate marks 13b are not superimposed on the mask marks 15, and the first substrate marks 13a, the second substrate marks 13b and the mask marks 15 have a predetermined positional relationship shown in Fig. 5D.

As shown in Fig. 5D, the shadow mask 14 is aligned with the transparent substrate 11 such that a center of the first substrate mark 13a, a center of the second substrate mark 13b, and a center of the mask mark 15 form a right angled triangle. The alignment is carried out as follows.

A first line L1 and a second line L2 are recognized and an angle α is measured. The first line L1 passes through the center of the first substrate mark 13a and the center of the mask mark 15. The second line L2 passes through the center of the second substrate mark 13b and the center of the mask mark 15. The angle α is formed by the first line L1 and the second line L2.

Further, a deviation X in an X-axis direction and a deviation Y in a Y-axis direction with respect to a desired positional relationship between the mask mark 15 and the second substrate mark 13b are measured respectively.

Alignment accuracy is determined based on the measured angle α, the deviation X, and the deviation Y. When the angle α is a preset value and each of the deviation X and the deviation Y is zero, the shadow mask 14 is positioned with respect to the transparent substrate 11 with high accuracy.

The above embodiments may be modified as follows.

The material of the transparent electrodes 12 is not limited to ITO but may be IZO (indium zinc oxide), ZnO (zinc oxide), SnO₂ (stannic oxide) or others. However, the relationship between the film thickness of the transparent electrodes 12 and the transmittance of each wavelength of light varies according to the material. Therefore, by previously checking the relationship between the film thickness of the transparent electrodes 12 and the transmittance of an appropriate wavelength by experiments, an appropriate optical filter 17 can be selected at the time of alignment of the shadow mask 14.

The shape of the substrate mark 13 is not limited to a cross. For example, the substrate mark 13 may be formed in a shape of which the center is easily recognized such as a polygon including a right triangle or a rectangle, a circle, a star or other shapes.

The shape of the substrate mark 13 may be the same as that of the mask mark 15. In this case, the positional relationship between the shadow mask 14 and the transparent substrate 11 can be recognized based on the overlapping degree of the substrate mark 13 and the mask mark 15. The shape of the substrate mark 13 and the mask mark 15 may not be a shape of which the center is easily recognized.

The two substrate marks 13 are not necessarily arranged on a diagonal of the transparent substrate 11. The two substrate marks 13 may be arranged on two positions on one side of the transparent substrate 11 respectively. Each of the two substrate marks 13 may be arranged on any two sides of the transparent substrate 11. The position of the mask marks 15 also may be changed on the shadow mask 14.

The number of the substrate marks 13 and mask marks 15 is not necessarily two but may be one or three or more. If one substrate mark 13 and one mask mark 15 are arranged, the shape of the substrate mark 13 and the mask mark 15 preferably has a right angled portion. This is because the position is easily adjusted by the right angled portion.

A white light emitting organic EL element may be used as a white light source comprising the irradiation light source 16.

The optical filter 17 is not necessarily detachably attached to the irradiation light source 16 by being replaced one by one. The filter member having a plurality of optical filters 17 integrally with each other may be moved by a moving device such that an appropriate optical filter 17 is selected. Specifically, the filter member has a plurality of optical filters 17 having different transmission wavelengths with a predetermined distance therebetween. The moving device moves the filter member such that an appropriate optical filter 17 is arranged on a light path of the irradiation light from the irradiation light source 16.

The half mirror 18 does not need to be arranged between the irradiation light source 16 and the transparent substrate 11. For example, light may be irradiated slantly to the transparent substrate 11 such that light that passes through the transparent substrate 11 and is reflected by the shadow mask 14 advances in a direction deviated from the irradiation light source 16.

The substrate marks 13, the first substrate marks 13a, the second substrate marks 13b, and the mask marks 15 are recognized for adjusting the alignment of the shadow mask 14 with respect to the transparent substrate 11. The marks are not necessarily recognized by the reflection method but may be recognized by a transmission method shown in Fig. 6.

As shown in Fig. 6, in the transmission method, the irradiation light source 16 is arranged such that the irradiation light from the irradiation light source 16 passes by the side of the transparent substrate 11 and the side of the shadow mask 14. Further, a first prism 20a and a second prism 20b are provided. The first prism 20a reflects the irradiation light from the irradiation light source 16 so as to change the advancing direction of the light by 90 degrees. Specifically, the first prism 20a causes the light to advance in parallel with the shadow mask 14 under the shadow mask 14. The second prism 20b reflects the light from the first prism 20a so as to change the advancing direction of the light by 90 degrees. Specifically, the second prism 20b causes the light to pass through the shadow mask 14 and the transparent substrate 11 sequentially. The CCD camera 19 is arranged so as to receive the light that has passed through the transparent substrate 11. The transparent electrodes 12 and the substrate marks 13 are omitted in Fig. 6.

The shadow mask 14 may be aligned with the transparent substrate 11 by allowing only the substrate marks 13 to be recognized with the transmission method.

An XYZ stage or an XYZθ stage may be used for moving the shadow mask 14 for the alignment adjustment.

Quarts glass, optical glass, Pyrex (registered mark) glass, a silicon substrate, silicon, wafer substrate, a resin substrate, a plastic substrate, a film substrate, and various transparent substrates may be used as the transparent substrate 11.

A substrate mark (13) is formed on a transparent substrate (11) as an alignment mark. The substrate mark (13) is formed at the same time as transparent electrodes (12) are formed on the transparent substrate (11). The substrate mark (13) is formed of the same material as the transparent electrodes (12). A center wavelength of a transmission wavelength of a plurality of optical filters (17) is different from each other. An optical filter (17) corresponding to a thickness of the substrate mark (13) is selected from a plurality of optical filters (17). Light is irradiated from a white light source (16) to the substrate mark (13) via the selected optical filter (17). Accordingly, the substrate mark (13) is recognized and a shadow mask (14) is aligned with the transparent substrate (11).

## Claims

1. A method for manufacturing an organic EL element, being **characterized by**:
forming transparent electrodes (12) on a transparent substrate (11);
forming a substrate mark (13) on the transparent substrate (11) as an alignment mark, the substrate mark (13) being formed at the same time as the transparent electrodes (12) are formed on the transparent substrate (11), and the substrate mark (13) being formed of the same material as the transparent electrodes (12), and the substrate mark (13) having a thickness;
arranging the transparent substrate (11) above a shadow mask (14) so as to align the shadow mask (14) with the transparent substrate (11);
preparing a white light source (16) and a plurality of optical filters (17), wherein a center wavelength of a transmission wavelength of each of the optical filters (17) is different from each other;
selecting an optical filter (17) that corresponds to the thickness of the substrate mark (13) from the optical filters (17);
irradiating light from the white light source (16) to the substrate mark (13) via the selected optical filter (17), thereby aligning the shadow mask (14) with the transparent substrate (11) using the substrate mark (13); and
laminating an organic EL layer on the transparent electrodes (12) by deposition through the shadow mask (14).

2. The manufacturing method according to claim 1, **characterized in that** each of the optical filters (17) is detachably attached to the white light source (16).

3. The manufacturing method according to claim 1, **characterized in that** the substrate mark (13) is recognized by a reflection method in the step of aligning the shadow mask (14) with the transparent substrate (11)
